# EUROPEAN PATENT APPLICATION

(11) **EP 4 310 821 A1**
(43) Date of publication of application: **24.01.2024**
(21) Application number: 22771243.7
(22) Date of filing: 09.03.2022
(51) Int. Cl.: G09G 3/20, G09G 3/3233, G09G 3/36, H01L 27/32, G02F 1/133, H05B 33/02, H01L 51/50

(54) **DISPLAY DEVICE AND ELECTRONIC APPARATUS**

(30) Priority: 15.03.2021 JP 2021041680
(71) Applicant: Sony Semiconductor Solutions Corporation, Atsugi-shi, Kanagawa 243-0014 (JP)
(72) Inventor: ISHIJIMA Shun, Atsugi-shi, Kanagawa 243-0014 (JP); TOYOMURA Naobumi, Atsugi-shi, Kanagawa 243-0014 (JP)
(74) Representative: D Young & Co LLP
(86) International application number: PCT/JP2022/010313
(87) International publication number: WO 2022/196492

(57) **Abstract**

To achieve both reduction in pixel size and improvement in display quality.

A display device includes: a display element connected between a first node and a second node; a first transistor that performs control to supply a current corresponding to a gradation to the first node; and a pulse generation unit that supplies a pulse signal to the second node.

## Description

### TECHNICAL FIELD

The present disclosure relates to a display device and an electronic device.

### BACKGROUND ART

Since smart glasses and head-mounted displays (HMD) can easily display images such as 3D, augmented reality (AR), virtual reality (VR), mixed reality (MR), and substitutional reality (SR), they are expected to become more popular in the future.

The smart glass or the HMD has a built-in microdisplay. The microdisplay is a display device of several mm square, and is configured using a liquid crystal element or an organic EL element (see Patent Document 1).

In order to display high-definition pixel information on a microdisplay, it is necessary to reduce the pixel size and increase the number of pixels. In order to reduce the pixel size, it is desirable to reduce the number of transistors in the pixel circuit. A typical pixel circuit has four transistors. In a case where an organic EL element (hereinafter, OLED: Organic Light Emitting Devise) is used as the display element, it is necessary to lower the anode voltage of the OLED to the initialization voltage in a period other than the light emission period of the OLED, and a transistor for performing control of setting the anode voltage of the OLED to the initialization voltage is generally provided in the pixel circuit. Since this transistor is not originally used for light emission of the OLED, it can be omitted.

### CITATION LIST

### PATENT DOCUMENT

Patent Document 1: Japanese Patent Application Laid-Open No. 2019-53239

### SUMMARY OF THE INVENTION

### PROBLEMS TO BE SOLVED BY THE INVENTION

However, if the above-described transistor is omitted, there is a possibility that the OLED emits light during a correction period of the threshold voltage of the drive transistor performed before the light emission period of the OLED or a write period in which the signal line voltage is supplied to the gate of the drive transistor. If the OLED emits light before the light emission period of the OLED, the display quality deteriorates such as occurrence of black floating.

Therefore, the present disclosure provides a display device and an electronic device capable of achieving both reduction in pixel size and improvement in display quality.

### SOLUTIONS TO PROBLEMS

In order to solve the above problem, according to the present disclosure, there is provided a display device including:
a display element connected between a first node and a second node;
a first transistor that performs control to supply a current corresponding to a gradation to the first node; and
a pulse generation unit that supplies a pulse signal to the second node.

The pulse generation unit may supply the pulse signal synchronized with a display timing of the display element to the second node.

The pulse generation unit may switch a voltage level of the pulse signal between a first period including at least a part of a display period of the display element and a second period before the first period is started.

The pulse generation unit may set the voltage level of the pulse signal lower in the first period than in the second period.

The display device may further include
a pixel circuit that includes the first transistor and controls display of the display element,
in which the pixel circuit may have a first state in which the first node is set to an initialization voltage, a second state in which a threshold voltage of the first transistor is corrected, a third state in which a voltage corresponding to a gradation is supplied to a gate of the first transistor, and a fourth state in which the display element is caused to emit light with luminance corresponding to a gradation, and
the pulse generation unit may lower the voltage level of the pulse signal in the third state or the fourth state, and raise the voltage level of the pulse signal at a timing when the fourth state ends.

The display device may further include
a second transistor that supplies a voltage corresponding to a gradation to the gate of the first transistor in the third state,
in which the pulse generation unit may lower the voltage level of the pulse signal after a timing at which the second transistor is turned on in the third state.

The second transistor may be connected between a signal line and the gate of the first transistor, and
the signal line may supply an offset voltage in the first state and supply a voltage corresponding to a gradation in the third state.

The display device may further include
a third transistor cascode-connected together with the first transistor between a reference voltage node and the first node,
in which the pulse generation unit may lower the voltage level of the pulse signal in accordance with a timing at which the third transistor is turned on in the third state.

The display device may further include
a capacitor connected between a gate and a source of the first transistor,
in which the third transistor may be connected between the reference voltage node and the source of the first transistor, and
the first transistor may be connected between a drain of the third transistor and the first node.

The display device may further include
a capacitor connected between a gate and a source of the first transistor,
in which the third transistor may be connected between the reference voltage node and the drain of the first transistor, and
the first transistor may be connected between a source of the third transistor and the first node.

The pulse signal may be set to a voltage level at which the display element does not emit light until the voltage level is lowered in the third state or the fourth state.

The display device may further include
a pixel array unit including a plurality of pixels arranged in each of a first direction and a second direction intersecting each other,
in which the pixel may include the display element, and
the pulse generation unit may have a conductive pattern that supplies the pulse signal at a same timing to the display element of all the pixels in the pixel array unit.

The display element may have a plurality of stacked layers, and
one of the plurality of layers may be the conductive pattern being solid.

The display device may further include
a pixel array unit including a plurality of pixels arranged in each of a first direction and a second direction intersecting each other,
in which the pulse generation unit may control timing of the pulse signal for each of a plurality of pixel groups in the first direction in the pixel array unit.

The display element may have a plurality of stacked layers, and
one of the plurality of layers may include a plurality of conductive patterns corresponding to the plurality of pixel groups in the first direction in the pixel array unit.

The display device may further include:
a pixel array unit including a plurality of pixels arranged in each of a first direction and a second direction intersecting each other;
a plurality of scanning lines arranged corresponding to a plurality of pixel groups in the first direction; and
a scanning line drive unit that drives the plurality of scanning lines,
in which the scanning line drive unit may incorporate the pulse generation unit.

The display device may further include:
a pixel array unit including a plurality of pixels arranged in each of a first direction and a second direction intersecting each other;
a plurality of scanning lines arranged corresponding to a plurality of pixel groups in the first direction; and
a scanning line drive unit that drives the plurality of scanning lines,
in which the pulse generation unit may be disposed separately from the scanning line drive unit.

The display element may be a current-driven self-luminous element.

The display element may be an organic EL element or a liquid crystal element.

According to another aspect of the present disclosure, there is provided an electronic device including:
a display device; and
a video signal generation unit that generates a video signal displayed on the display device,
in which the display device includes:
   a display element connected between a first node and a second node;
   a first transistor that performs control to supply a current corresponding to a gradation to the first node; and
   a pulse generation unit that supplies a pulse signal to the second node.

### BRIEF DESCRIPTION OF DRAWINGS

Fig. 1A is a block diagram illustrating a schematic configuration of a display device according to an embodiment of the present disclosure.
Fig. 1B is a block diagram of a modification of the display device of Fig. 1A.
Fig. 2 is a circuit diagram illustrating an example of an internal configuration of a pixel circuit.
Fig. 3 is an operation timing diagram of the pixel circuit of Fig. 2.
Fig. 4A is a circuit diagram illustrating a modification of the pixel circuit of Fig. 2.
Fig. 4B is a circuit diagram illustrating another modification of the pixel circuit of Fig. 2.
Fig. 5 is a circuit diagram of a pixel circuit according to a comparative example.
Fig. 6 is an operation timing diagram of the pixel circuit of Fig. 4.
Fig. 7 is a circuit diagram of a pixel circuit in which an AZ transistor is omitted from the pixel circuit of Fig. 4.
Fig. 8 is an operation timing diagram of the pixel circuit of Fig. 6.
Fig. 9 is a circuit diagram of a pixel circuit according to a first modification of the pixel circuit of Fig. 2.
Fig. 10 is a circuit diagram of a second modification of the pixel circuit.
Fig. 11 is an operation timing diagram of the pixel circuit of Fig. 9.
Fig. 12 is a circuit diagram of a third modification of the pixel circuit.
Fig. 13 is an operation timing diagram of the pixel circuit of Fig. 11.
Fig. 14 is a schematic plan view illustrating an example of a layout pattern of a pulse signal output from a pulse generation unit.
Fig. 15 is a cross-sectional view taken along line A-A in Fig. 13.
Fig. 16 is a schematic plan view illustrating an example of a layout pattern capable of line controlling a cathode voltage of an OLED.
Fig. 17 is a cross-sectional view taken along line A-A in Fig. 15.
Fig. 18A is a view illustrating an internal state of a conveyance from a rear side to a front side of the conveyance.
Fig. 18B is a view illustrating an internal state of the conveyance from an oblique rear side to an oblique front side of the conveyance.
Fig. 19A is a front view of a digital camera as a second application example of an electronic device.
Fig. 19B is a rear view of the digital camera.
Fig. 20A is an external view of an HMD as a third application example of the electronic device.
Fig. 20B is an external view of a smart glass.
Fig. 21 is an external view of a TV as a fourth application example of the electronic device.
Fig. 22 is an external view of a smartphone as a fifth application example of the electronic device.

### MODE FOR CARRYING OUT THE INVENTION

Hereinafter, embodiments of a display device and an electronic device will be described with reference to the drawings. Hereinafter, while principal components of the display device and the electronic device will be mainly described, the display device and the electronic device may have components and functions that are not illustrated or described. The following description does not exclude components and functions that are not illustrated or described.

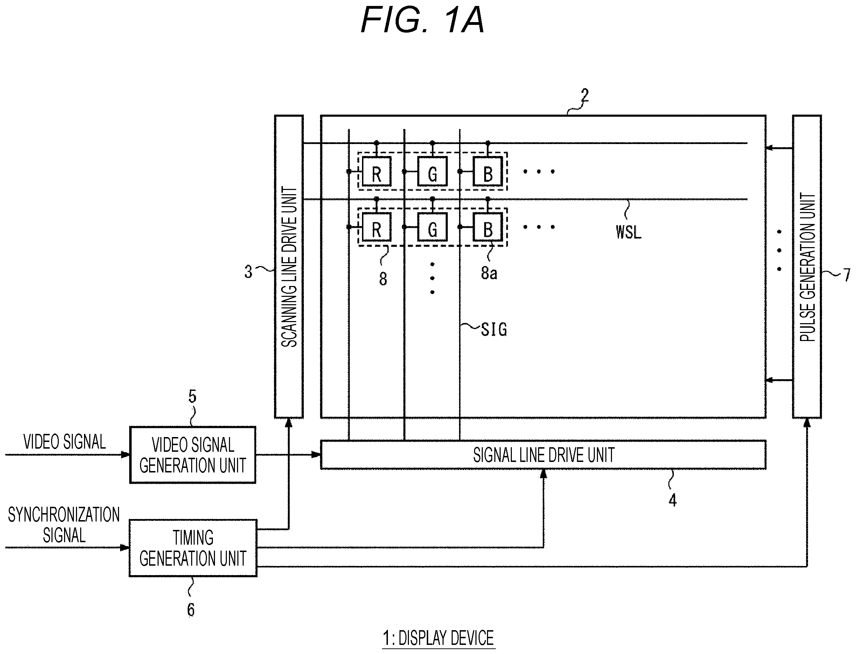

Fig. 1A is a block diagram illustrating a schematic configuration of a display device 1 according to an embodiment of the present disclosure. The display device 1 in Fig. 1A is, for example, an active matrix type microdisplay. The display device 1 of Fig. 1A includes a pixel array unit 2, a scanning line drive unit 3, a signal line drive unit 4, a video signal processing unit 5, a timing generation unit 6, and a pulse generation unit 7.

The pixel array unit 2 includes a plurality of pixels 8 arranged in each of the row direction and the column direction. Each pixel 8 has a plurality of subpixels 8a. The plurality of subpixels 8a includes, for example, three subpixels 8a of red, blue, and green. The plurality of subpixels 8a may include subpixels 8a of colors other than red, blue, and green (for example, white). In the present specification, the subpixels 8a may be collectively referred to as a pixel 8.

Each subpixel 8a in the pixel 8 includes a display element and a pixel circuit as described later. The display element is connected between a first node n1 and a second node n2. The display element is, for example, an OLED. Note that the display element may be a liquid crystal element or a self-luminous element other than the OLED. As described later, the first node n1 is connected to, for example, the drain of the drive transistor, and a pulse signal is supplied to the second node n2.

The pixel array unit 2 includes a plurality of scanning lines WSL arranged for each pixel group in the row direction and a plurality of signal lines SIG arranged for each pixel group in the column direction. The pixel 8 is provided near each intersection of the scanning line WSL and the signal line SIG. In the present specification, the row direction may be referred to as a horizontal line direction, and the column direction may be referred to as a vertical line direction.

The scanning line drive unit 3 sequentially drives the plurality of scanning lines WSL. The signal line drive unit 4 drives the plurality of signal lines SIG in the horizontal line direction at the same timing in synchronization with the timing at which the scanning line WSL drives each horizontal line. Driving the signal line SIG means supplying a gradation signal corresponding to each signal line SIG.

The video signal processing unit 5 performs predetermined signal processing on a video signal supplied from the outside (for example, a processor or the like) to generate a gradation signal. The predetermined signal processing is, for example, processing such as gamma correction and overdrive correction.

The timing generation unit 6 supplies a timing control signal to the scanning line drive unit 3 and the signal line drive unit 4 on the basis of a synchronization signal supplied from the outside, and operates the scanning line drive unit 3 and the signal line drive unit 4 in synchronization.

The pulse generation unit 7 supplies a pulse signal to the second node n2 of the display element. In a case where the display element is an OLED, the pulse generation unit 7 supplies a pulse signal to the cathode of the OLED. The pulse signal is a signal that periodically repeats a first voltage level and a second voltage level lower than the first voltage level. By supplying the pulse signal to the cathode of the OLED, the anode-cathode voltage of the OLED can be changed in synchronization with the pulse signal. When the anode-cathode voltage exceeds a predetermined threshold voltage, the OLED emits light with luminance corresponding to the current flowing through the OLED. The pulse generation unit 7 controls light emission of the OLED by supplying a pulse signal to the cathode of the OLED.

In this manner, the pulse generation unit 7 supplies the pulse signal synchronized with the display timing of the display element to the second node n2. More specifically, the pulse generation unit 7 switches the voltage level of the pulse signal between the first period including at least a part of the display period of the display element and the second period before the start of the first period. For example, the pulse generation unit 7 sets the voltage level of the pulse signal to be lower in the first period than in the second period.

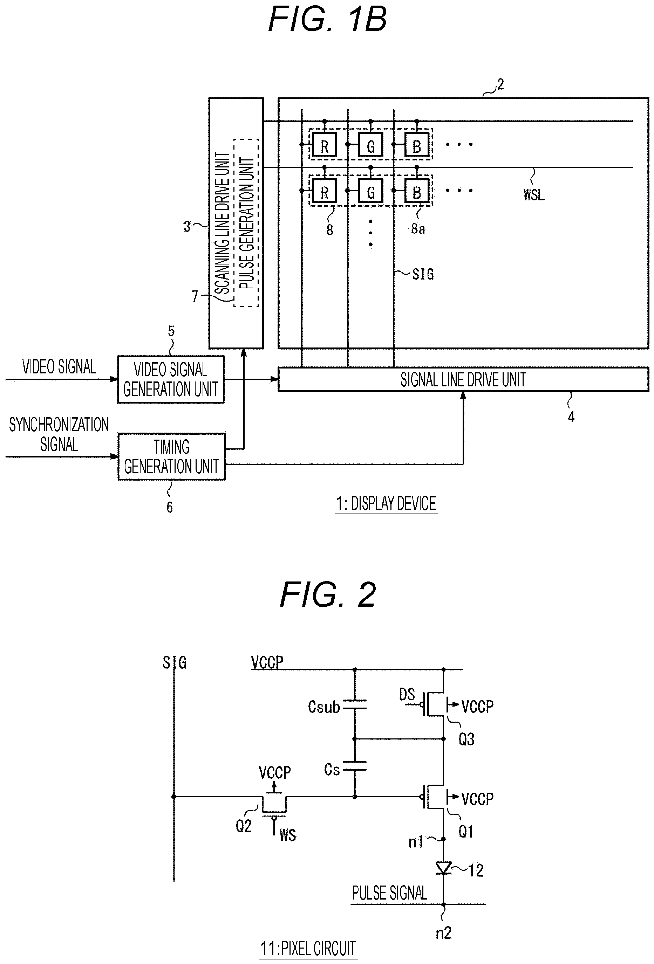

In Fig. 1A, the pulse generation unit 7 is provided separately from the scanning line drive unit 3, but as illustrated in a modification of the display device 1 illustrated in Fig. 1B, the pulse generation unit 7 may be built in the scanning line drive unit 3. Note that, in the display device 1 of Figs. 1A and 1B, the scanning line drive unit 3 may be disposed on both sides in the horizontal direction.

The number of pixels in the pixel array unit 2 in Figs. 1A and 1B is not particularly limited. In the high-definition display device 1 having a large number of pixels, the scanning line drive unit 3 may be arranged on both end sides in the horizontal line direction. Furthermore, in order to drive the plurality of signal lines SIG in the horizontal line direction separately, a plurality of signal line drive units 4 may be provided. In addition, an arrangement place of the pulse generation unit 7 is also arbitrary.

Fig. 2 is a circuit diagram illustrating an example of an internal configuration of a pixel circuit 11. Fig. 2 illustrates an example of the pixel circuit 11 that controls light emission of an OLED 12 in a case where the OLED 12 is used as a display element. The pixel circuit 11 of Fig. 2 includes three transistors Q1 to Q3 called 3Tr2C and two capacitors (a first capacitor Cs and a second capacitor Csub). In the present specification, the three transistors Q1 to Q3 in the pixel circuit 11 are referred to as a drive transistor (first transistor) Q1, a sampling transistor (second transistor) Q2, and a drive scan transistor (third transistor) Q3. The drive transistor Q1 may be abbreviated as a Drv transistor Q1, the sampling transistor Q2 may be referred to as a WS transistor Q2, and the drive scan transistor Q3 may be referred to as a DS transistor Q3.

In the pixel circuit 11 of Fig. 2, an example in which the Drv transistor Q1, the WS transistor Q2, and the DS transistor Q3 are configured by P-type MOS transistors is illustrated, but as will be described later, the Drv transistor Q1, the WS transistor Q2, and the DS transistor Q3 may be configured by N-type MOS transistors.

The DS transistor Q3 and the Drv transistor Q1 are cascode-connected between the power supply voltage node VCCP and the anode of the OLED 12. The WS transistor Q2 is connected between the signal line SIG and the gate of the Drv transistor Q1. In Fig. 2, the signal input to the gate of the WS transistor Q2 is referred to as a WS signal, and the signal input to the gate of the DS transistor Q3 is referred to as a DS signal. A gradation signal and an offset signal are supplied to the signal line SIG at different timings.

The first capacitor Cs is connected between the gate and the source of the Drv transistor Q1. In addition, a second capacitor Csub is connected between the source and the drain of the DS transistor Q3. That is, the first capacitor Cs and the second capacitor Csub are connected in series between the power supply voltage node VCCP and the gate of the Drv transistor Q1. The first capacitor Cs may be referred to as a pixel capacitance, and the second capacitor Csub may be referred to as an auxiliary capacitance.

The pulse signal output from the pulse generation unit 7 is supplied to the cathode of the OLED 12. As a result, the voltage between the anode and the cathode of the OLED 12 varies in synchronization with the pulse signal.

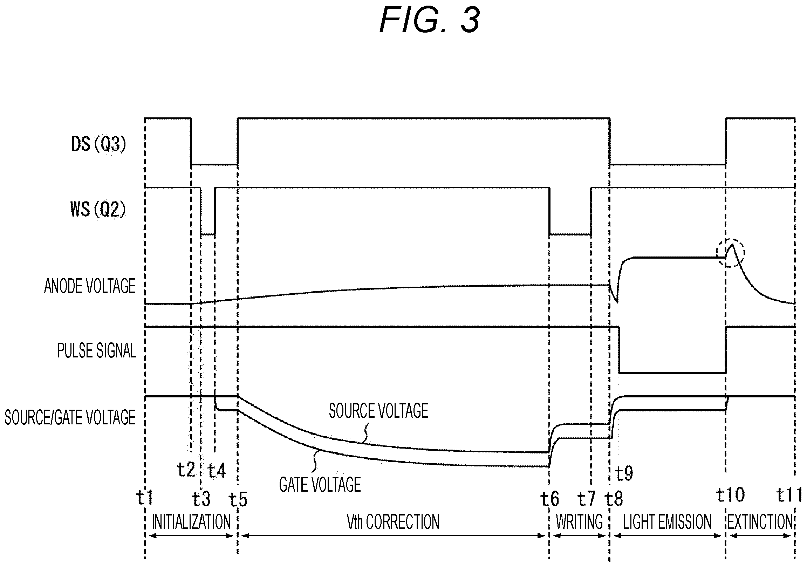

Fig. 3 is an operation timing diagram of the pixel circuit 11 of Fig. 2. Hereinafter, the operation of the pixel circuit 11 in Fig. 2 will be described with reference to Fig. 3.

As illustrated in Fig. 3, when the OLED 12 emits light, the pixel circuit 11 sequentially transitions between an initialization period (first state), a Vth correction period (second state), a write period (third state), a light emission period (fourth state), and an extinction period (fifth state).

First, in the initialization period, the anode of the OLED 12 is set to the initialization voltage. In Fig. 3, time t1 to time t5 are set as an initialization period. At time t1, the WS transistor Q2 and the DS transistor Q3 are in an off state. At this point, the Drv transistor Q1 is also in the off state, and the anode voltage of the OLED 12 is substantially 0 V.

When the DS signal becomes low at time t2, the DS transistor Q3 is turned on, and the source voltage of the Drv transistor Q1 rises. Thereafter, when the WS signal becomes low at time t3, the WS transistor Q2 is turned on, and the offset signal on the signal line SIG is supplied to the gate of the Drv transistor Q1 via the WS transistor Q2. As a result, the drain voltage of the Drv transistor Q1, that is, the anode voltage of the OLED 12 gradually increases, and a charge corresponding to the current flowing between the source and the drain of the DS transistor Q3 is accumulated in the first capacitor Cs.

At time t4, the WS transistor Q2 is turned off, but since the accumulated charge of the first capacitor Cs is held, a current flows between the source and the drain of the Drv transistor Q1, and the anode voltage of the OLED 12 gradually increases. Fig. 3 illustrates the source voltage waveform and the gate voltage waveform of the Drv transistor Q1, but after time t3, a potential difference corresponding to the accumulated charge of the first capacitor Cs is generated between the source and the drain of the Drv transistor Q1.

When the DS transistor Q3 is turned off at time t5, the accumulated charge of the first capacitor Cs is gradually discharged, and is finally stabilized at a point when the voltage across both ends of the first capacitor Cs matches the threshold voltage of the Drv transistor Q1, and the anode voltage of the OLED 12 gradually increases until that time. Time t5 to t6 is a Vth correction period for correcting the threshold voltage of the Drv transistor Q1.

At time t6, the WS transistor Q2 is turned on, and the signal on the signal line SIG is supplied to the gate of the Drv transistor Q1 through the WS transistor Q2. The signal on the signal line SIG is switched from the offset signal to the gradation signal between times t6 and t7. Therefore, at time t7 at a point when the WS transistor Q2 is turned off, the gate voltage of the Drv transistor Q1 becomes a voltage level corresponding to the gradation signal. Time t6 to t8 is a write period in which the gate of the Drv transistor Q1 is set to a voltage corresponding to the gradation signal.

At time t8, the DS transistor Q3 is turned on, and a current can flow from the power supply voltage node VCCP to the source of the Drv transistor Q1 through the DS transistor Q3. The Drv transistor Q1 supplies a current corresponding to the gradation signal to the anode of the OLED 12.

At time t9, the pulse signal supplied to the cathode of the OLED 12 transitions from high to low. As a result, the voltage between the anode and the cathode of the OLED 12 rapidly rises, and the OLED 12 starts emitting light. A period from time t8 to time t10 is a light emission period.

At time t10, the DS transistor Q3 is turned off, and the Drv transistor Q1 stops flowing current to the anode of the OLED 12, so that light emission is stopped. The pulse signal supplied to the cathode of the OLED 12 also changes from low to high at time t10. As a result, the voltage between the anode and the cathode of the OLED 12 decreases, and the OLED 12 stops emitting light. During the period from time t10 to time t11, since the current does not flow from the DS transistor Q3 to the Drv transistor Q1, the source-drain voltage of the Drv transistor Q1 also decreases, the anode voltage of the OLED 12 rapidly decreases, and the OLED 12 is turned off.

In the operation timing diagram of Fig. 3, the pulse signal is set to a high potential (first voltage level) until time t9. While the pulse signal is at a high potential, the voltage between the anode and the cathode of the OLED 12 does not exceed the threshold of the OLED 12, so that light emission of the OLED 12 can be suppressed.

As described above, for example, the pulse generation unit 7 lowers the voltage level of the pulse signal within the write period or the light emission period, and raises the voltage level of the pulse signal at the timing when the light emission period ends.

In the operation timing diagram of Fig. 3, the pulse signal is caused to transition from high to low at time t9 in the light emission period, but the timing at which the logic of the pulse signal transitions is not necessarily limited to that illustrated in Fig. 3.

The present inventor has examined whether or not the OLED 12 emits light before the light emission period by changing the timing at which the pulse signal transitions from high (first voltage level) to low (second voltage level) in a plurality of ways. As a result, it has been found that the light emission of the OLED 12 can be suppressed before the light emission period by causing the pulse signal to transition from high to low after the period from time t6 to time t7 when the WS transistor Q2 is turned on. Therefore, it is desirable that the pulse generation unit 7 control the timing of the pulse signal so that the pulse signal transitions from high to low after the time when the WS transistor Q2 transitions from off to on in the write period.

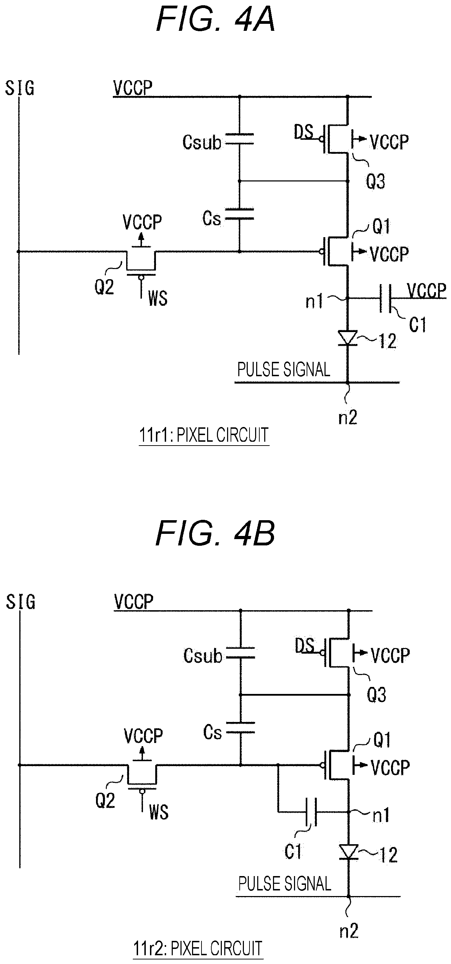

As indicated by a broken line circle in Fig. 3, there is a concern that the anode voltage of the OLED 12 temporarily increases at the timing when the pulse signal changes from low potential to high potential when the OLED 12 is turned off from light emission, and the black current in the extinction period increases. As a countermeasure, for example, a pixel circuit 11r1 illustrated in Fig. 4A or a pixel circuit 11r2 illustrated in Fig. 4B can be considered.

The pixel circuit 11r1 in Fig. 4A or the pixel circuit 11r2 in Fig. 4B is obtained by adding the capacitor C1 to the pixel circuit 11 in Fig. 2, but the connection destinations of the capacitors C1 are different from each other.

In the pixel circuit 11r1 of Fig. 4A, the capacitor C1 is connected between the anode of the OLED 12 and the power supply voltage node VCCP. When the pulse signal changes from a low potential to a high potential, the anode potential of the OLED 12 tends to increase, but since one end of the capacitor C1 is connected to the anode of the OLED 12 and the other end of the capacitor C1 is connected to the power supply voltage node VCCP whose potential is stable, it is possible to suppress an increase in the anode potential of the OLED 12.

Furthermore, in the pixel circuit 11r2 in Fig. 4B, the capacitor C1 is connected between the anode of the OLED 12 and the gate of the Drv transistor Q1. When the pulse signal changes from a low potential to a high potential, the anode potential of the OLED 12 tends to increase, but one end of the capacitor C1 is connected to the anode of the OLED 12, and the other end of the capacitor C1 is connected to the gate of the Drv transistor Q1. Since the power supply voltage node VCCP is connected to the gate of the Drv transistor Q1 via the capacitor Cs and the capacitor Csub, it is possible to suppress an increase in the anode voltage of the OLED 12 similarly in Fig. 4A.

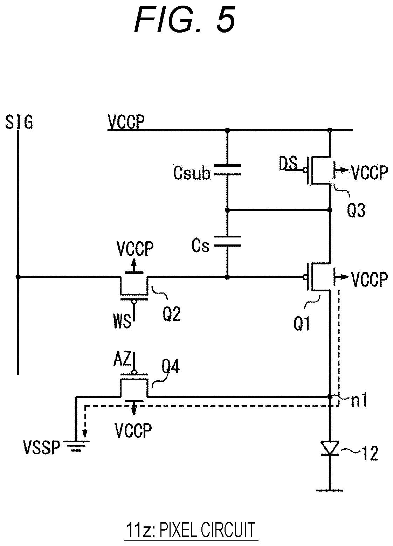

Fig. 5 is a circuit diagram of a pixel circuit 11z according to a comparative example. In the pixel circuit 11z of Fig. 5, the same components as those of the pixel circuit 11 of Fig. 2 are denoted by the same reference numerals, and differences will be mainly described below.

The pixel circuit 11z in Fig. 5 includes an AZ transistor Q4 in addition to the pixel circuit 11 in Fig. 2. The AZ transistor Q4 is connected between the anode of the OLED 12 and the ground voltage node VSSP. An AZ signal is supplied to the gate of the AZ transistor Q4. In a case where the AZ transistor Q4 is a P-type MOS transistor, when the AZ signal is low, a source-drain current of the Drv transistor Q1 passes through the AZ transistor Q4 and flows to the ground voltage node VSSP. Therefore, during the period when the AZ transistor Q4 is on, an increase in the anode voltage of the OLED 12 is suppressed, and the current does not flow through the OLED 12. In the pixel circuit 11z of Fig. 5, the cathode of the OLED 12 is fixed to a predetermined voltage (for example, ground voltage), and the pulse signal as in Fig. 2 is not supplied.

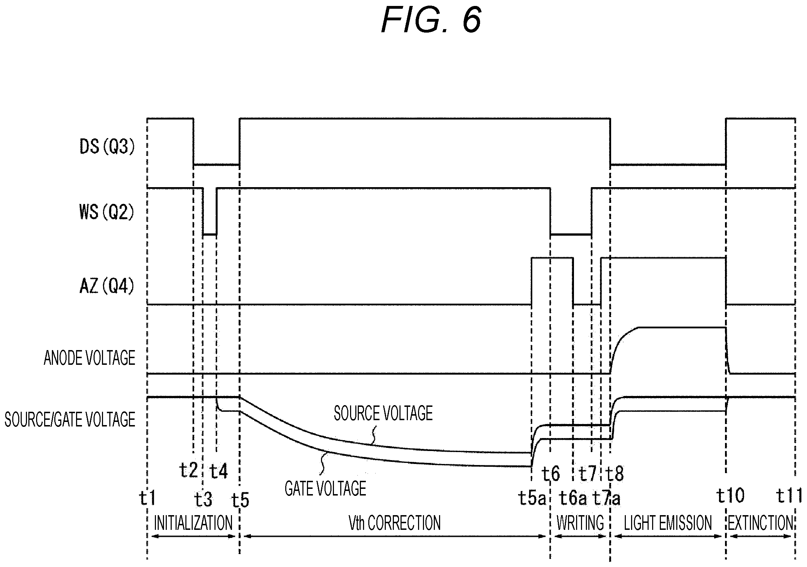

Fig. 6 is an operation timing diagram of the pixel circuit 11z of Fig. 5. Fig. 6 illustrates the operation in the period t1 to t11 in accordance with Fig. 3, and hereinafter, the operation different from that in Fig. 3 will be mainly described.

In the pixel circuit 11z of Fig. 5, the AZ transistor Q4 is in an on state until the middle of the Vth correction period (time t5a). As a result, in Fig. 3, the anode voltage of the OLED 12 gradually increases after time t3, but in Fig. 6, the anode voltage of the OLED 12 is maintained at the ground voltage VSSP after time t3 until the end of the write period (until time t8) .

More specifically, the AZ transistor Q4 is turned off from time t5a during the Vth correction period to time t6a during the write period, and then turned on between times t6a and t7a. As a result, the anode voltage of the OLED 12 is maintained at the ground voltage VSSP until time t8 when the write period ends. In the pixel circuit 11z of Fig. 5, the cathode of the OLED 12 is fixed to a predetermined voltage, but since the anode voltage maintains the ground voltage VSSP until the light emission period comes, the anode-cathode voltage of the OLED 12 also remains low, and the light emission of the OLED 12 can be suppressed.

After time t7a, until the light emission period ends (until time t10), the AZ transistor Q4 is turned off. Therefore, when the DS transistor Q3 is turned on at time t8 in the light emission period, a current according to the gradation signal flows through the OLED 12, and the anode-cathode voltage of the OLED 12 also increases, so that the OLED 12 emits light.

In the pixel circuit 11z of Fig. 5, the source-drain current of the Drv transistor Q1 is released from the AZ transistor Q4 to the ground voltage node VSSP until the light emission period comes, so that the increase in the anode voltage of the OLED 12 is suppressed, and the OLED 12 does not emit light. However, since the pixel circuit 11z in Fig. 5 includes the four transistors Q1 to Q4, it is difficult to reduce the size of the pixel circuit 11, which hinders high definition of the display device 1.

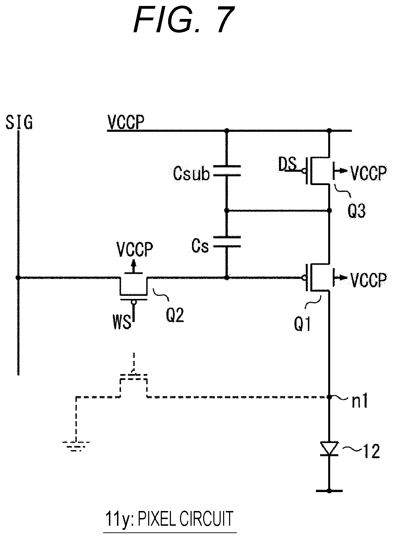

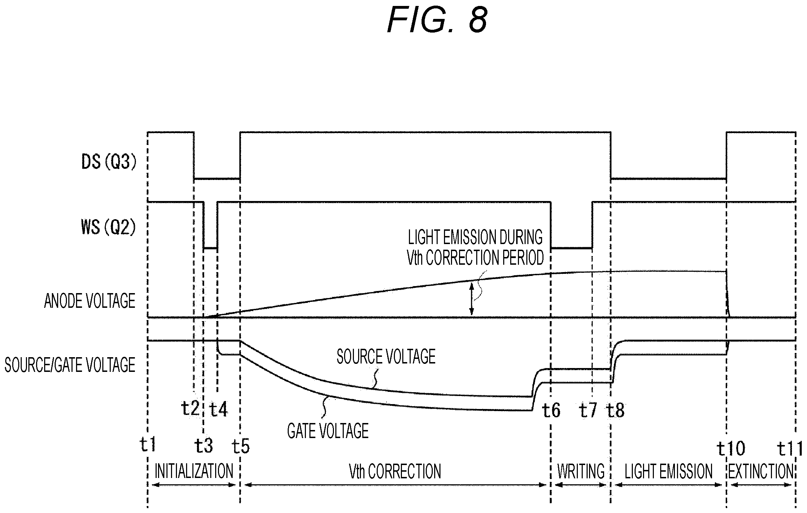

Fig. 7 is a circuit diagram of a pixel circuit 11y in which the AZ transistor Q4 is omitted from the pixel circuit 11z of Fig. 5. Fig. 8 is an operation timing diagram of the pixel circuit 11y in Fig. 7. In the pixel circuit 11y in Fig. 7, when the source-drain current starts flowing through the Drv transistor Q1 after time t3, the anode voltage of the OLED 12 gradually increases, and a current also flows through the anode of the OLED 12. As a result, the OLED 12 emits light in the middle of the Vth correction period. If the OLED 12 emits light before the original light emission period, black floating or the like occurs and the display quality deteriorates.

In this manner, simply omitting the AZ transistor Q4 is not preferable because the anode voltage of the OLED 12 increases during the Vth correction period or the write period, and thus the OLED 12 may emit light before the start of the light emission period. Therefore, in the pixel circuit 11 according to the present embodiment, as illustrated in Fig. 2, a pulse signal is supplied to the cathode of the OLED 12, and the anode voltage of the OLED 12 is controlled by the pulse signal, so that the OLED 12 does not emit light before the start of the light emission period. The pulse signal is set to a voltage level at which the OLED 12 does not emit light until the voltage level is lowered within the write period or the light emission period.

The pixel circuit 11 according to the present embodiment is not necessarily limited to the circuit configuration illustrated in Fig. 2, and various modifications are conceivable.

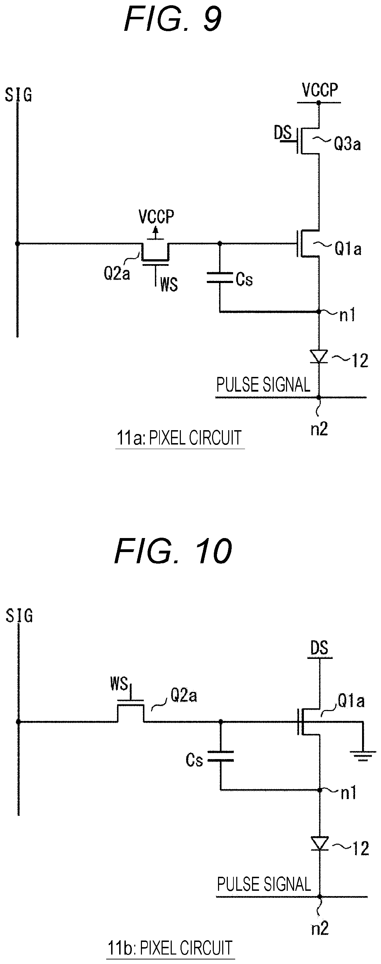

The pixel circuit 11 in Fig. 2 includes the three transistors Q1 to Q3 including P-type MOS transistors, but may include N-type MOS transistors. Fig. 9 is a circuit diagram of a pixel circuit 11a according to a first modification in which the transistors Q1 to Q3 in the pixel circuit 11 of Fig. 2 are configured by N-type MOS transistors Q1a, Q2a, and Q3a. The pixel circuit 11a of Fig. 9 performs a similar operation to the pixel circuit 11 of Fig. 2 although the conductivity type is different.

Fig. 10 is a circuit diagram of a second modification of the pixel circuit 11. The pixel circuit 11b in Fig. 10 has a configuration of 2Tr2C, and the DS transistor Q3 in Fig. 2 is omitted, so that the circuit area can be reduced as compared with the pixel circuit 11 in Fig. 2. The pixel circuit 11b in Fig. 10 illustrates an example in which the Drv transistor Q1a and the WS transistor Q2a are N-type MOS transistors, but may be configured by P-type MOS transistors.

The DS signal is supplied to the drain of the Drv transistor Q1a in Fig. 10. The source of the Drv transistor Q1a is connected to the anode of the OLED 12. A pulse signal from the pulse generation unit 7 is supplied to the cathode of the OLED 12. The connection between the WS transistor Q2a and the first capacitor Cs is similar to that of the pixel circuit 11 of Fig. 2.

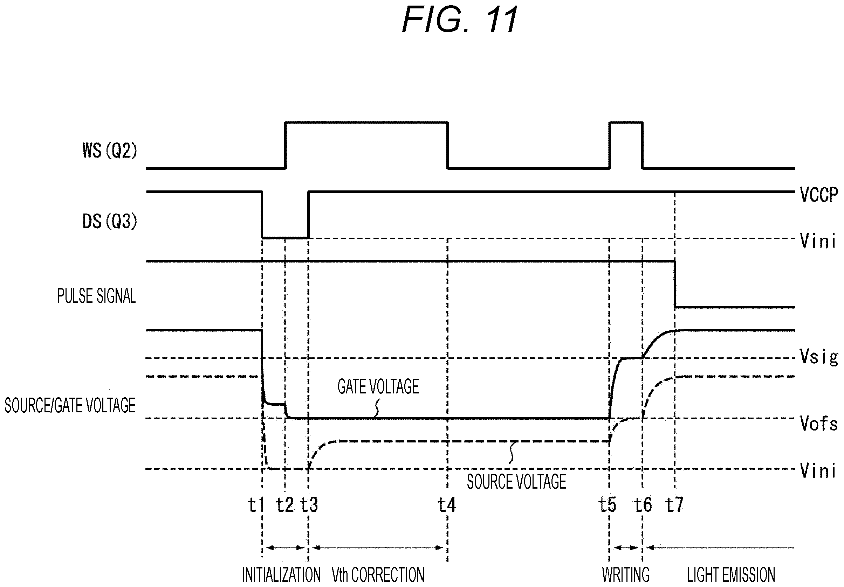

Fig. 11 is an operation timing diagram of the pixel circuit 11b of Fig. 10. At the point of time t1, a predetermined charge is accumulated in the first capacitor Cs, and the voltage between the gate and the source of the Drv transistor Q1a is set to a voltage corresponding to the accumulated charge of the first capacitor Cs.

At time t1, when the DS signal decreases to Vini, the source voltage of the Drv transistor Q1a decreases to Vini, and accordingly, the gate voltage of the Drv transistor Q1a also decreases.

Thereafter, the WS transistor Q2a is turned on at time t2, and the offset voltage Vofs on the signal line SIG is supplied to the gate of the Drv transistor Q1a through the WS transistor Q2a. At this time, the source voltage of the Drv transistor Q1a is a voltage Vini sufficiently lower than the offset voltage Vofs, and the gate-source voltage Vgs of the Drv transistor Q1a is Vofs - Vini. Time t1 to t3 are initialization periods.

Thereafter, at time t3, the DS signal rises to VCCP. As a result, the source voltage of the Drv transistor Q1a starts to rise. Eventually, at a point when the gate-source voltage of the Drv transistor Q1a becomes equal to the threshold voltage Vth of the Drv transistor Q1a, the source voltage of the Drv transistor Q1a is stabilized. Time t3 to t4 is a Vth correction period.

A pulse signal is supplied to the cathode of the OLED 12, and the pulse signal is set to a high potential until around time t5. As a result, there is no possibility that the OLED 12 emits light within the Vth correction period.

Thereafter, at time t5, the WS transistor Q2a is turned on again. At this time, since the gradation signal is supplied to the signal line SIG, the gradation signal is supplied to the gate of the Drv transistor Q1a via the WS transistor Q2a. As a result, the gate of the Drv transistor Q1a becomes a voltage corresponding to the gradation signal, a current flows between the drain and the source of the Drv transistor Q1a, this current flows to the equivalent capacitance of the OLED 12, and the anode voltage of the OLED 12 increases. Time t5 to t6 are write periods.

At time t6, the WS transistor Q2a is turned off. As a result, the gate of the Drv transistor Q1a enters a floating state, but the gate-source voltage of the Drv transistor Q1a is a voltage value corresponding to the accumulated charge of the first capacitor Cs, and a current flows between the drain and the source of the Drv transistor Q1a. This current flows through the anode of the OLED 12, and the OLED 12 starts emitting light. Time t6 to t7 are the light emission period.

The pulse signal supplied to the cathode of the OLED 12 transitions from a high potential to a low potential after time t5 when the WS transistor Q2a is turned on. Fig. 11 illustrates an example in which the pulse signal transitions to a low potential at time t7. By controlling the timing at which the pulse signal transitions to the low potential, there is no possibility that the OLED 12 emits light before the light emission period.

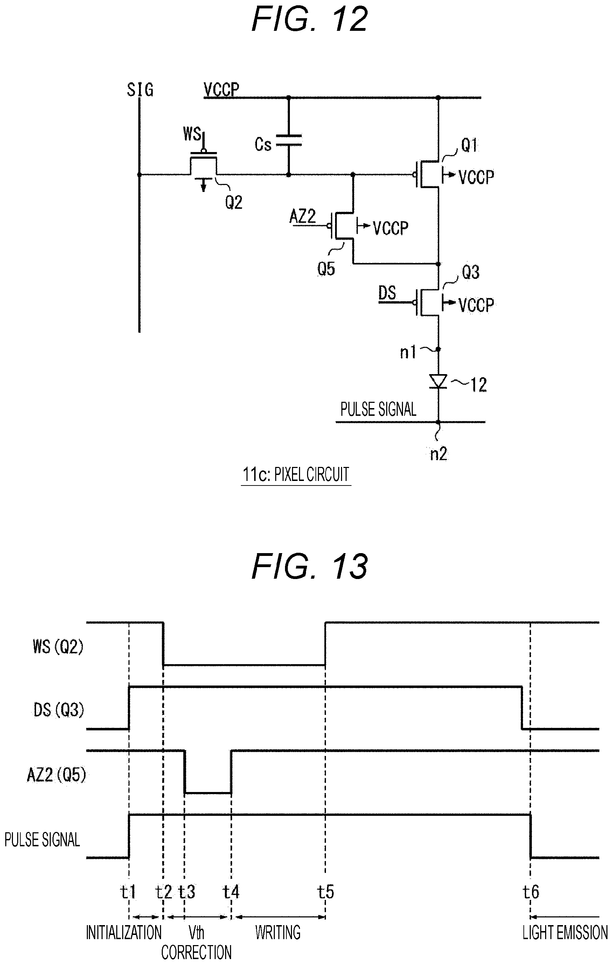

Fig. 12 is a circuit diagram of a third modification of the pixel circuit 11. In the pixel circuit 11c of Fig. 12, the connection order of the Drv transistor Q1 and the DS transistor Q3 is reversed from that of the pixel circuit 11 of Fig. 2. The pixel circuit 11c in Fig. 12 has a circuit configuration of 4Tr1C. Each transistor in the pixel circuit 11c in Fig. 12 is a P-type MOS transistor, but may be configured by an N-type MOS transistor.

The pixel circuit 11c of Fig. 12 includes a Drv transistor Q1 and a DS transistor Q3 cascode-connected between the power supply voltage node VCCP and the anode of the OLED 12. The WS transistor Q2 is connected between the signal line SIG and the gate of the Drv transistor Q1. The transistor Q5 is connected between the gate and the drain of the Drv transistor Q1. An AZ2 signal is supplied to the gate of the transistor Q5. The first capacitor Cs is connected between the gate of the Drv transistor Q1 and the power supply voltage node VCCP.

Fig. 13 is an operation timing diagram of the pixel circuit 11c of Fig. 12. Time t1 to t2 are initialization periods. In the initialization period, both the WS transistor Q2 and the DS transistor Q3 are turned off. Time t2 to t4 are the Vth correction period. At time t2, the WS transistor Q2 is turned on. Thereafter, the transistor Q5 is turned on at time t3. As a result, the gate and the drain of the Drv transistor Q1 are connected and diode-connected. As a result, a current flows from the power supply voltage node to the signal line SIG through between the source and the drain of the Drv transistor Q1, between the drain and the source of the transistor Q5, and between the drain and the source of the WS transistor Q2. Although the gate voltage of the Drv transistor Q1 increases due to this current, as the gate voltage approaches VCCP-Vth, the current in the above-described path hardly flows, and eventually, the gate voltage of the Drv transistor Q1 is saturated at VCCP-Vth. As a result, the first capacitor Cs holds the charge of the threshold voltage Vth of the Drv transistor Q1.

Time t4 to t5 are write periods. Since the transistor Q5 is turned off at the time t4, the diode connection of the Drv transistor Q1 is released. At this point, since the WS transistor Q2 is in the on state, the gradation signal from the signal line SIG is supplied to the gate of the Drv transistor Q1 via the WS transistor Q2.

Thereafter, at time t6, the DS transistor Q3 is turned on, a current flows through the OLED 12, and the OLED 12 emits light.

Also in the pixel circuit 11c of Fig. 12, the pulse signal from the pulse generation unit 7 is supplied to the cathode of the OLED 12. By lowering the pulse signal from the high potential to the low potential after the period in which the WS signal is turned on, the OLED 12 can be caused to emit light after the write period.

The pulse signal generated by the pulse generation unit 7 may be supplied to the cathodes of the OLEDs 12 of all the pixels 8 in the pixel array unit 2 at a common timing. In this case, it is desirable that noise is not superimposed on the pulse signal.

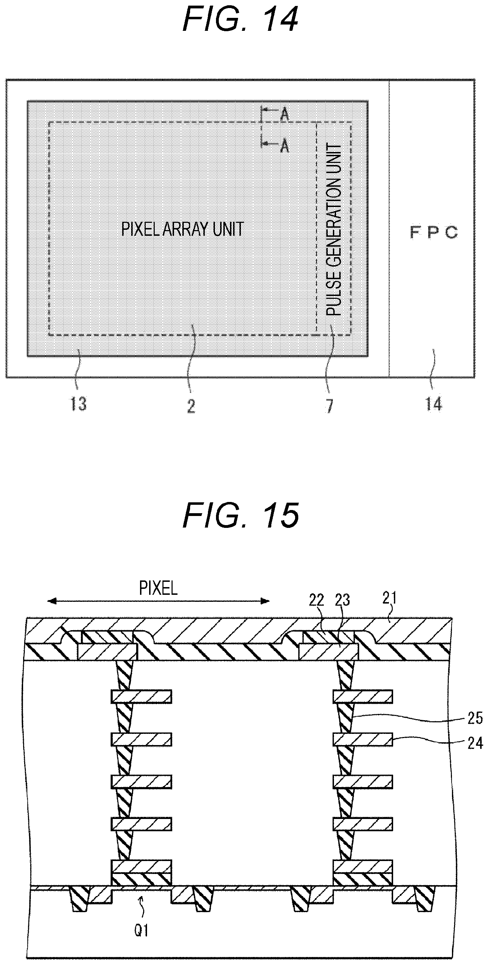

Fig. 14 is a schematic plan view illustrating an example of a layout pattern 13 of the pulse signal output from the pulse generation unit 7. The display device 1 according to the present embodiment is formed by laminating a plurality of layers on a base substrate such as a glass substrate, and the example of Fig. 14 illustrates an example in which one of the plurality of layers constituting the display device 1 is a solid pattern 13 for a pulse signal. The solid pattern 13 also serves as a cathode electrode layer of the OLED 12. In Fig. 14, the outer peripheral edge of the pixel array unit 2 arranged in another layer is illustrated by a broken line. In addition, Fig. 2 illustrates an example in which the display device 1 is connected to, for example, a flexible printed circuit (FPC) 14.

Fig. 15 is a cross-sectional view taken along line A-A in Fig. 14. Fig. 15 illustrates a cross-sectional structure below a cathode electrode layer 21 of the display device 1. As illustrated in Fig. 15, cathode electrode layers 21 of the plurality of OLEDs 12 are constituted by the solid pattern 13. The cathode electrode layer 21 is electrically connected to an output node of the pulse generation unit 7. As illustrated in Fig. 15, in the OLED 12, the cathode electrode layer 21, an organic EL layer 22, and an anode electrode layer 23 are laminated in this order from the top to the bottom. The anode electrode layer 23 is arranged separately for each pixel 8 (subpixel 8a), whereas the cathode electrode is integrated, resulting in the solid pattern 13 as illustrated in Fig. 14 in a plan view. In addition, under the anode electrode layer 23, a plurality of wiring layers 24 is laminated via contacts 25. The number of a plurality of stacked wiring layers 24 is arbitrary. Furthermore, the transistors Q1 and Q2 and the like in the pixel circuit 11 are formed below the lowermost wiring layer 24.

As described above, by forming the cathode electrode layer 21 into the solid pattern 13, it is difficult to be affected by noise, and display quality can be improved.

The pulse generation unit 7 may individually control the cathode voltage of the OLED 12 for each of the lines of pixels 8 in the pixel array unit 2. This enables line control of the cathode voltage of the OLED 12.

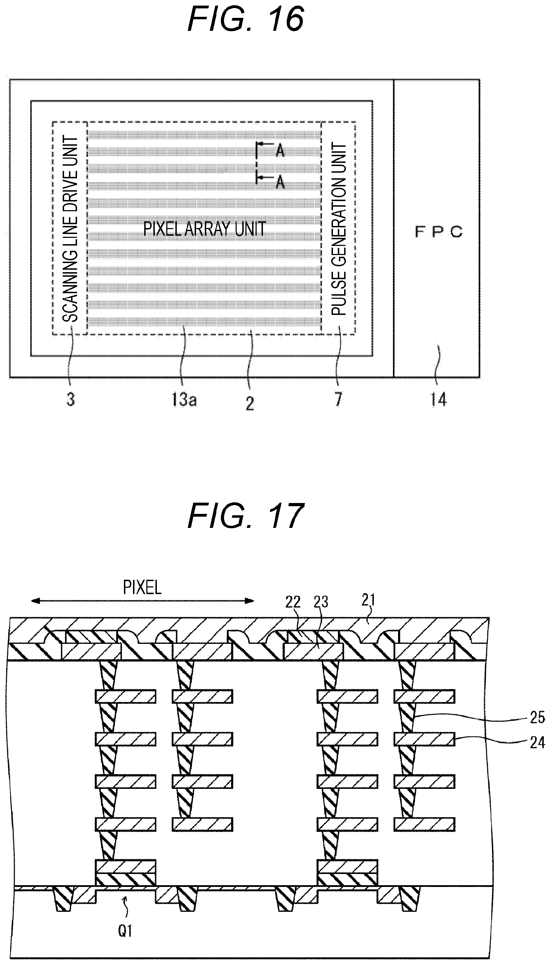

Fig. 16 is a schematic plan view illustrating an example of a layout (wiring) pattern 13a capable of line controlling the cathode voltage of the OLED 12. As illustrated in the drawing, a plurality of wiring patterns 13a for line control of the cathode voltage of the OLED 12 is arranged. Each wiring pattern 13a is electrically connected to the cathode of each OLED 12 on the corresponding pixel 8 lines. The pulse generation unit 7 can individually control the timing of the pulse signal supplied to the plurality of wiring patterns 13a.

Fig. 17 is a cross-sectional view taken along line A-A in Fig. 16. As illustrated in Fig. 16, the cathode electrode layers 21 are physically separated and arranged for each of the lines of pixels 8.

As described above, in the present embodiment, since the pulse signal is supplied to the cathode of the OLED 12 and the voltage between the anode and the cathode of the OLED 12 is controlled by the pulse signal, it is possible to prevent a failure in which the OLED 12 emits light before the light emission period starts. Consequently, the display quality can be improved.

According to the present embodiment, since the anode-cathode voltage of the OLED 12 can be controlled by controlling the cathode voltage of the OLED 12 by the pulse signal, it is not necessary to provide a transistor for bypassing the current flowing from the Drv transistor Q1 to the anode of the OLED 12, and the number of transistors constituting the pixel circuit 11 can be reduced. Therefore, since the circuit size of the pixel circuit 11 can be reduced and the number of pixels in the pixel array unit 2 can be increased accordingly, the definition of the display device 1 can be increased.

Furthermore, since the pixel circuit 11 according to the present embodiment can be realized by only a partial change of the pixel circuit 11 having an existing circuit configuration, design change is easy, and a problem in implementation does not occur.

### (Application Example of Display Device 1 and Electronic Device 50 According to Present Disclosure)

### (First Application Example)

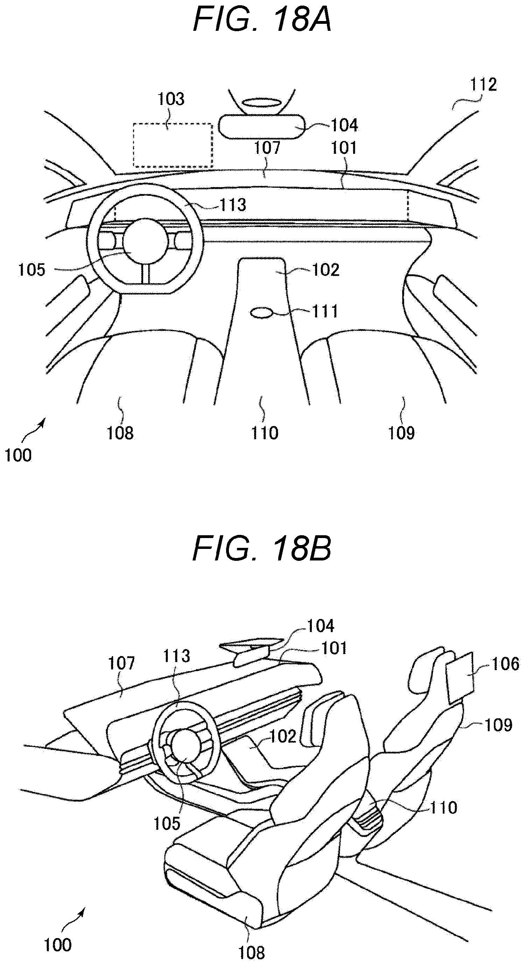

The display device 1 according to the present disclosure can be mounted on various electronic devices. Figs. 18A and 18B are views illustrating an internal configuration of a conveyance 100 as a first application example of the electronic device 50 including the display device 1 according to the present disclosure. Fig. 18A is a view illustrating an internal state of the conveyance 100 from a rear side to a front side of the conveyance 100, and Fig. 18B is a view illustrating an internal state of the conveyance 100 from an oblique rear side to an oblique front side of the conveyance 100.

The conveyance 100 of Figs. 18A and 18B includes a center display 101, a console display 102, a head-up display 103, a digital rear mirror 104, a steering wheel display 105, and a rear entertainment display 106.

The center display 101 is arranged on a dashboard 107 at a position facing a driver seat 108 and a passenger seat 109. Fig. 18 illustrates an example of the center display 101 having a horizontally long shape extending from the driver seat 108 side to the passenger seat 109 side, but any screen size and arrangement location of the center display 101 may be adopted. The center display 101 can display information sensed by the various sensors. As a specific example, the center display 101 can display a captured image captured by an image sensor, an image of a distance to an obstacle in front of or on a side of the conveyance measured by a ToF sensor, a passenger's body temperature detected by an infrared sensor, and the like. The center display 101 can be used to display, for example, at least one of safety-related information, operation-related information, a life log, health-related information, authentication/identification-related information, or entertainment-related information.

The safety-related information is information of doze sensing, looking-away sensing, sensing of mischief of a child riding together, presence or absence of wearing of a seat belt, sensing of leaving of an occupant, and the like, and is information sensed by the sensor arranged to overlap with a back surface side of the center display 101, for example. The operation-related information senses a gesture related to an operation by the occupant by using the sensor. The sensed gestures may include an operation of various types of equipment in the conveyance 100. For example, operations of air conditioning equipment, a navigation device, an AV device, a lighting device, and the like are sensed. The life log includes a life log of all the occupants. For example, the life log includes an action record of each occupant in the conveyance. By acquiring and storing the life log, it is possible to check a state of the occupant at a time of an accident. The health-related information senses a body temperature of an occupant by using the temperature sensor, and estimates a health condition of the occupant on the basis of the sensed body temperature. Alternatively, the face of the occupant may be imaged by using an image sensor, and the health condition of the occupant may be estimated from the imaged facial expression. Moreover, a conversation may be made with the occupant in automatic voice, and the health condition of the occupant may be estimated on the basis of an answer content of the occupant. The authentication/identification-related information includes a keyless entry function of performing face authentication by using the sensor, a function of automatically adjusting a seat height and position in face identification, and the like. The entertainment-related information includes a function of detecting operation information of the AV device by the occupant by using the sensor, a function of recognizing the face of the occupant by the sensor and providing a content suitable for the occupant by the AV device, and the like.

The console display 102 can be used to display the life log information, for example. The console display 102 is arranged near a shift lever 111 of a center console 110 between the driver seat 108 and the passenger seat 109. The console display 102 can also display information sensed by the various sensors. Furthermore, the console display 102 may display an image of a periphery of the vehicle captured by the image sensor, or may display an image of a distance to an obstacle in the periphery of the vehicle.

The head-up display 103 is virtually displayed behind a windshield 112 in front of the driver seat 108. The head-up display 103 can be used to display, for example, at least one of safety-related information, operation-related information, a life log, health-related information, authentication/identification-related information, or entertainment-related information. Since the head-up display 103 is virtually arranged in front of the driver seat 108 in many cases, the head-up display 103 is suitable for displaying information directly related to an operation of the conveyance 100 such as a speed of the conveyance 100 and a remaining amount of fuel (a battery).

The digital rear mirror 104 can also display a state of an occupant in the rear seat in addition to the rear side of the conveyance 100, and thus can be used to display the life log information, for example, by arranging the sensor to overlap with a back surface side of the digital rear mirror 104.

The steering wheel display 105 is arranged near a center of a steering wheel 113 of the conveyance 100. The steering wheel display 105 can be used to display, for example, at least one of safety-related information, operation-related information, a life log, health-related information, authentication/identification-related information, or entertainment-related information. In particular, since the steering wheel display 105 is close to the driver's hand, the steering wheel display 105 is suitable for displaying the life log information such as a body temperature of the driver, or for displaying information regarding an operation of the AV device, air conditioning equipment, or the like.

The rear entertainment display 106 is attached to a back side of the driver seat 108 and the passenger seat 109, and is for viewing by an occupant in the rear seat. The rear entertainment display 106 can be used to display, for example, at least one of safety-related information, operation-related information, a life log, health-related information, authentication/identification-related information, or entertainment-related information. In particular, since the rear entertainment display 106 is in front of the occupant in the rear seat, information related to the occupant in the rear seat is displayed. For example, information regarding an operation of the AV device or the air conditioning equipment may be displayed, or a result of measuring a body temperature or the like of the occupant in the rear seat by the temperature sensor may be displayed.

By irradiating the target object with light from the sensor and receiving reflected light from the target object, a distance to an object existing in the surroundings can be measured. Optical distance measurement methods are roughly classified into a passive type and an active type. In the passive type, distance measurement is performed by receiving light from an object without projecting light from the sensor to the object. The passive type includes a lens focus method, a stereo method, a monocular vision method, and the like. In the active type, distance measurement is performed by projecting light onto an object, and receiving reflected light from the object with the sensor to measure a distance. Examples of the active type include an optical radar method, an active stereo method, an illuminance difference stereo method, a moire topography method, and an interference method. The display device 1 according to the present disclosure can be applied to any of these types of distance measurement. By using the sensor arranged to overlap with the back surface side of the display device 1 according to the present disclosure, the distance measurement of the passive type or the active type described above can be performed.

### (Second Application Example)

The display device 1 according to the present disclosure is applicable not only to various displays used in conveyances but also to displays mounted on various electronic devices 50.

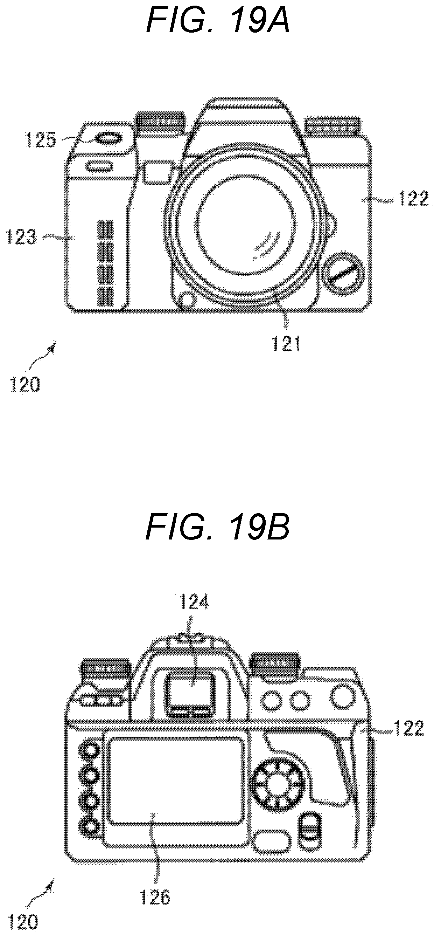

Fig. 19A is a front view of a digital camera 120 as a second application example of the electronic device 50, and Fig. 19B is a rear view of the digital camera 120. The digital camera 120 in Figs. 19A and 19B illustrates an example of a single-lens reflex camera in which a lens 121 is replaceable, but the display device 1 is also applicable to a camera in which the lens 121 is not replaceable.

In the camera of Figs. 19A and 19B, when a person who captures an image looks into an electronic viewfinder 124 to determine a composition while holding a grip 123 of a camera body 122, and presses a shutter 125 while adjusting focus, image-capturing data is stored in a memory in the camera. As illustrated in Fig. 19B, on a back side of the camera, a monitor screen 126 that displays captured data and the like and a live image and the like, and the electronic viewfinder 124 are provided. Furthermore, a sub screen that displays setting information such as a shutter speed and an exposure value may be provided on an upper surface of the camera.

The amount of information displayed on the monitor screen 126, the electronic viewfinder 124, the sub screen, and the like used for the camera also tends to increase, and the usability of the camera can be improved by applying the high-resolution display device 1 according to the present disclosure.

### (Third Application Example)

The display device 1 according to the present disclosure is also applicable to a head-mounted display (hereinafter, referred to as an HMD). The HMD can be used for virtual reality (VR), augmented reality (AR), mixed reality (MR), substitutional reality (SR), and the like.

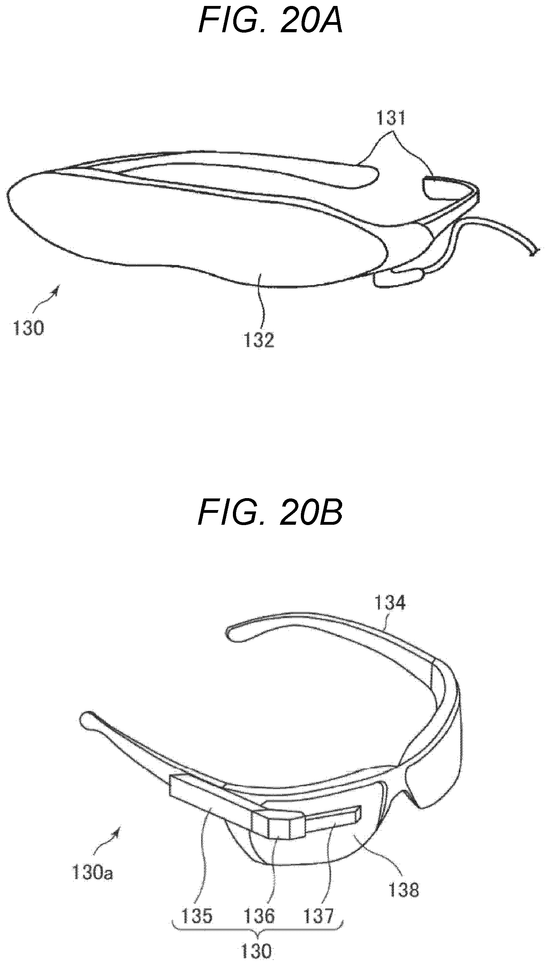

Fig. 20A is an external view of an HMD 130 as a third application example of the electronic device 50. The HMD 130 of Fig. 20A includes a mounting member 131 for attachment to cover human eyes. The mounting member 131 is hooked and fixed to a human ear, for example. A display device 132 is provided inside the HMD 130, and a wearer of the HMD 130 can visually recognize a stereoscopic image and the like with the display device 132. The HMD 130 includes, for example, a wireless communication function, an acceleration sensor, and the like, and can switch a stereoscopic image and the like displayed on the display device 132 in accordance with a posture, a gesture, and the like of the wearer. The display device 1 illustrated in Fig. 1A or 1B is applicable to the display device 132 in Fig. 20A.

Furthermore, a camera may be provided in the HMD 130 to capture an image around the wearer, and an image obtained by combining the captured image of the camera and an image generated by a computer may be displayed on the display device 132. For example, arranging a camera to overlap with a back surface side of the display device 132 visually recognized by the wearer of the HMD 130, capturing an image of a periphery of an eye of the wearer with the camera, and displaying the captured image on another display provided on an outer surface of the HMD 130, a person around the wearer can grasp expression of the face and a movement of the eyes of the wearer in real time.

Note that various types of the HMD 130 are conceivable. For example, as illustrated in Fig. 20B, the display device 1 according to the present disclosure can also be applied to a smart glass 130a that displays various types of information on glasses 134. The smart glass 130a in Fig. 20B includes a main body portion 135, an arm portion 136, and a lens barrel portion 137. The main body portion 135 is connected to the arm portion 136. The main body portion 135 is detachable from the glasses 134. The main body portion 135 incorporates a display unit and a control board for control of an operation of the smart glass 130a. The main body portion 135 and the lens barrel are connected to each other via the arm portion 136. The lens barrel portion 137 emits image light emitted from the main body portion 135 through the arm portion 136, to a lens 138 side of the glasses 134. This image light enters human eyes through the lens 138. A wearer of the smart glass 130a in Fig. 20B can visually recognize not only a surrounding situation but also various pieces of information emitted from the lens barrel portion 137 similarly to normal glasses.

### (Fourth Application Example)

The display device 1 according to the present disclosure is also applicable to a television device (hereinafter, a TV). In recent TVs, a frame tends to be as small as possible from the viewpoint of downsizing and design property. Therefore, in a case where a camera to capture an image of a viewer is provided on a TV, it is desirable to arrange the camera so as to overlap with a back surface side of the display panel of the TV.

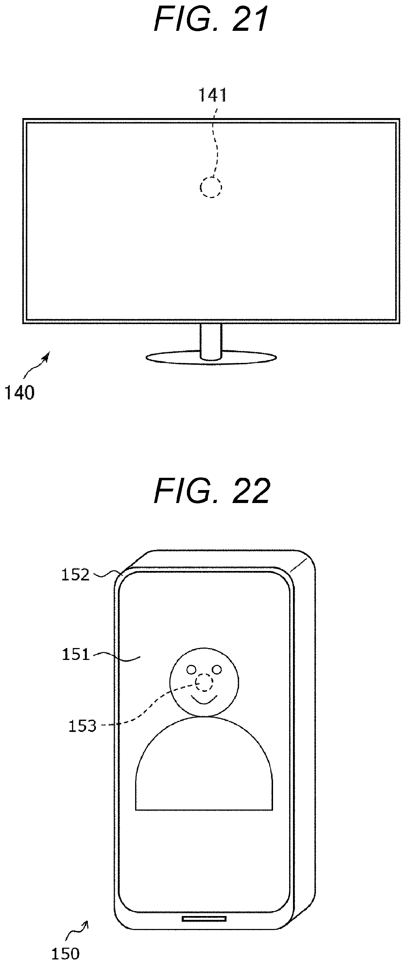

Fig. 21 is an external view of a TV 140 as a fourth application example of the electronic device 50. In the TV 140 of Fig. 21, a frame is minimized, and almost the entire region on a front side is a display area. The TV 140 incorporates a sensor 141 such as a camera to capture an image of a viewer. The sensor 141 in Fig. 21 may be disposed on a back side of a part (for example, a broken line portion) in the display panel, or may be disposed in a frame of the display panel. Furthermore, the sensor 141 may be an image sensor 141 module, or various sensors 141 such as a sensor 141 for face authentication, a sensor 141 for distance measurement, and a temperature sensor 141 can be applied, and a plurality of types of sensors 141 may be arranged on the back surface side of the display panel of the TV 140 or on the frame of the display panel.

As described above, according to the display device 1 of the present disclosure, the TV 140 having high resolution and excellent display quality can be realized.

### (Fifth Application Example)

The display device 1 according to the present disclosure is also applicable to a smartphone and a mobile phone. Fig. 22 is an external view of a smartphone 150 as a fifth application example of the electronic device 50. In the example of Fig. 22, a display surface 151 expands to be close to the outer size of the electronic device 50, and a bezel 152 around the display surface 151 has a width of several millimeters or less. Normally, a front camera is often mounted on the bezel 152. However, in Fig. 22, as indicated by a broken line, at least some pixels in the display surface are of a transmissive type, so that an image sensor module 153 functioning as a front camera can be disposed on the back surface side of the substantially central portion of the display surface 151, for example. By providing the front camera on a back surface side of the display surface 151 in this manner, it is not necessary to arrange the front camera in the bezel 152, and the width of the bezel 152 can be narrowed.

Note that the present technology can have the following configurations.
(1) A display device including:
   a display element connected between a first node and a second node;
   a first transistor that performs control to supply a current corresponding to a gradation to the first node; and
   a pulse generation unit that supplies a pulse signal to the second node.
(2) The display device according to (1), in which the pulse generation unit supplies the pulse signal synchronized with a display timing of the display element to the second node.
(3) The display device according to (1) or (2), in which the pulse generation unit switches a voltage level of the pulse signal between a first period including at least a part of a display period of the display element and a second period before the first period is started.
(4) The display device according to (3), in which the pulse generation unit sets a voltage level of the pulse signal to be lower in the first period than in the second period.
(5) The display device according to (4), further including
   a pixel circuit that includes the first transistor and controls display of the display element,
   in which the pixel circuit has a first state in which the first node is set to an initialization voltage, a second state in which a threshold voltage of the first transistor is corrected, a third state in which a voltage corresponding to a gradation is supplied to a gate of the first transistor, and a fourth state in which the display element is caused to emit light with luminance corresponding to a gradation, and
   the pulse generation unit lowers the voltage level of the pulse signal in the third state or the fourth state, and raises the voltage level of the pulse signal at a timing when the fourth state ends.
(6) The display device according to (5), further including
   a second transistor that supplies a voltage corresponding to a gradation to the gate of the first transistor in the third state,
   in which the pulse generation unit lowers the voltage level of the pulse signal after a timing at which the second transistor is turned on in the third state.
(7) The display device according to (6),
   in which the second transistor is connected between a signal line and the gate of the first transistor, and
   the signal line supplies an offset voltage in the first state and supplies a voltage corresponding to a gradation in the third state.
(8) The display device according to (5), further including
   a third transistor cascode-connected together with the first transistor between a reference voltage node and the first node,
   in which the pulse generation unit lowers the voltage level of the pulse signal in accordance with a timing at which the third transistor is turned on in the third state.
(9) The display device according to (8), further including
   a capacitor connected between a gate and a source of the first transistor,
   in which the third transistor is connected between the reference voltage node and the source of the first transistor, and
   the first transistor is connected between a drain of the third transistor and the first node.
(10) The display device according to (8), further including
   a capacitor connected between a gate and a source of the first transistor,
   in which the third transistor is connected between the reference voltage node and the drain of the first transistor, and
   the first transistor is connected between a source of the third transistor and the first node.
(11) The display device according to any one of (5) to (10), in which the pulse signal is set to a voltage level at which the display element does not emit light until the voltage level is lowered in the third state or the fourth state.
(12) The display device according to any one of (1) to (11), further including
   a pixel array unit including a plurality of pixels arranged in each of a first direction and a second direction intersecting each other,
   in which the pixel includes the display element, and
   the pulse generation unit has a conductive pattern that supplies the pulse signal at a same timing to the display element of all the pixels in the pixel array unit.
(13) The display device according to (12),
   in which the display element has a plurality of stacked layers, and
   one of the plurality of layers is the conductive pattern being solid.
(14) The display device according to any one of (1) to (10), further including
   a pixel array unit including a plurality of pixels arranged in each of a first direction and a second direction intersecting each other,
   in which the pulse generation unit controls timing of the pulse signal for each of a plurality of pixel groups in the first direction in the pixel array unit.
(15) The display device according to (14),
   in which the display element has a plurality of stacked layers, and
   one of the plurality of layers includes a plurality of conductive patterns corresponding to the plurality of pixel groups in the first direction in the pixel array unit.
(16) The display device according to any one of (1) to (11), further including:
   a pixel array unit including a plurality of pixels arranged in each of a first direction and a second direction intersecting each other;
   a plurality of scanning lines arranged corresponding to a plurality of pixel groups in the first direction; and
   a scanning line drive unit that drives the plurality of scanning lines,
   in which the scanning line drive unit incorporates the pulse generation unit.
(17) The display device according to any one of (1) to (11), further including:
   a pixel array unit including a plurality of pixels arranged in each of a first direction and a second direction intersecting each other;
   a plurality of scanning lines arranged corresponding to a plurality of pixel groups in the first direction; and
   a scanning line drive unit that drives the plurality of scanning lines,
   in which the pulse generation unit is disposed separately from the scanning line drive unit.
(18) The display device according to any one of (1) to (17), in which the display element is a current-driven self-luminous element.
(19) The display device according to any one of (1) to (17), in which the display element is an organic EL element or a liquid crystal element.
(20) An electronic device including:
   a display device; and
   a video signal generation unit that generates a video signal displayed on the display device,
   in which the display device includes:
      a display element connected between a first node and a second node;
      a first transistor that performs control to supply a current corresponding to a gradation to the first node; and
      a pulse generation unit that supplies a pulse signal to the second node.

Aspects of the present disclosure are not limited to the above-described individual embodiments, but include various modifications that can be conceived by those skilled in the art, and the effects of the present disclosure are not limited to the above-described contents. That is, various additions, modifications, and partial deletions can be made without departing from the conceptual idea and spirit of the present disclosure derived from the contents defined in the claims and equivalents thereof.

### REFERENCE SIGNS LIST

- 1: Display device
- 2: Pixel array unit
- 3: Scanning line drive unit
- 4: Signal line drive unit
- 5: Video signal processing unit
- 6: Timing generation unit
- 7: Pulse generation unit
- 8: Pixel
- 8a: Subpixel
- 11, 11a, 11b, 11c, 11y, 11z: Pixel circuit
- 13: Solid pattern
- 13a: Wiring pattern
- 21: Cathode electrode layer
- 22: Organic EL layer
- 23: Anode electrode layer
- 24: Wiring layer
- 25: Contact
- 50: Electronic device
- 100: Conveyance
- 101: Center display
- 102: Console display
- 103: Head-up display
- 104: Digital rear mirror
- 105: Steering wheel display
- 106: Rear entertainment display
- 107: Dashboard
- 108: Driver seat
- 109: Passenger seat
- 110: Center console
- 111: Shift lever
- 112: Windshield
- 113: Steering wheel
- 120: Digital camera
- 121: Lens
- 122: Camera body
- 123: Grip
- 124: Electronic viewfinder
- 125: Shutter
- 126: Monitor screen
- 130: Smart glass
- 131: Mounting member
- 132: Display device
- 134: Glasses
- 135: Main body portion
- 136: Arm portion
- 137: Lens barrel portion
- 138: Lens
- 140: TV
- 141: Sensor
- 150: Smartphone
- 151: Display surface
- 152: Bezel
- 153: Image sensor module

## Claims

1. A display device comprising:
a display element connected between a first node and a second node;
a first transistor that performs control to supply a current corresponding to a gradation to the first node; and
a pulse generation unit that supplies a pulse signal to the second node.

2. The display device according to claim 1, wherein the pulse generation unit supplies the pulse signal synchronized with a display timing of the display element to the second node.

3. The display device according to claim 1, wherein the pulse generation unit switches a voltage level of the pulse signal between a first period including at least a part of a display period of the display element and a second period before the first period is started.

4. The display device according to claim 3, wherein the pulse generation unit sets the voltage level of the pulse signal lower in the first period than in the second period.

5. The display device according to claim 4, further comprising
a pixel circuit that includes the first transistor and controls display of the display element,
wherein the pixel circuit has a first state in which the first node is set to an initialization voltage, a second state in which a threshold voltage of the first transistor is corrected, a third state in which a voltage corresponding to a gradation is supplied to a gate of the first transistor, and a fourth state in which the display element is caused to emit light with luminance corresponding to a gradation, and
the pulse generation unit lowers the voltage level of the pulse signal in the third state or the fourth state, and raises the voltage level of the pulse signal at a timing when the fourth state ends.

6. The display device according to claim 5, further comprising
a second transistor that supplies a voltage corresponding to a gradation to the gate of the first transistor in the third state,
wherein the pulse generation unit lowers the voltage level of the pulse signal after a timing at which the second transistor is turned on in the third state.

7. The display device according to claim 6,
wherein the second transistor is connected between a signal line and the gate of the first transistor, and
the signal line supplies an offset voltage in the first state and supplies a voltage corresponding to a gradation in the third state.

8. The display device according to claim 5, further comprising
a third transistor cascode-connected together with the first transistor between a reference voltage node and the first node,
wherein the pulse generation unit lowers the voltage level of the pulse signal in accordance with a timing at which the third transistor is turned on in the third state.

9. The display device according to claim 8, further comprising
a capacitor connected between a gate and a source of the first transistor,
wherein the third transistor is connected between the reference voltage node and the source of the first transistor, and
the first transistor is connected between a drain of the third transistor and the first node.

10. The display device according to claim 8, further comprising
a capacitor connected between a gate and a source of the first transistor,
wherein the third transistor is connected between the reference voltage node and the drain of the first transistor, and
the first transistor is connected between a source of the third transistor and the first node.

11. The display device according to claim 5, wherein the pulse signal is set to a voltage level at which the display element does not emit light until the voltage level is lowered in the third state or the fourth state.

12. The display device according to claim 1, further comprising
a pixel array unit including a plurality of pixels arranged in each of a first direction and a second direction intersecting each other,
wherein the pixel includes the display element, and
the pulse generation unit has a conductive pattern that supplies the pulse signal at a same timing to the display element of all the pixels in the pixel array unit.

13. The display device according to claim 12,
wherein the display element has a plurality of stacked layers, and
one of the plurality of layers is the conductive pattern being solid.

14. The display device according to claim 1, further comprising
a pixel array unit including a plurality of pixels arranged in each of a first direction and a second direction intersecting each other,
wherein the pulse generation unit controls timing of the pulse signal for each of a plurality of pixel groups in the first direction in the pixel array unit.

15. The display device according to claim 14,
wherein the display element has a plurality of stacked layers, and
one of the plurality of layers includes a plurality of conductive patterns corresponding to the plurality of pixel groups in the first direction in the pixel array unit.

16. The display device according to claim 1, further comprising:
a pixel array unit including a plurality of pixels arranged in each of a first direction and a second direction intersecting each other;
a plurality of scanning lines arranged corresponding to a plurality of pixel groups in the first direction; and
a scanning line drive unit that drives the plurality of scanning lines,
wherein the scanning line drive unit incorporates the pulse generation unit.

17. The display device according to claim 1, further comprising:
a pixel array unit including a plurality of pixels arranged in each of a first direction and a second direction intersecting each other;
a plurality of scanning lines arranged corresponding to a plurality of pixel groups in the first direction; and
a scanning line drive unit that drives the plurality of scanning lines,
wherein the pulse generation unit is disposed separately from the scanning line drive unit.

18. The display device according to claim 1, wherein the display element is a current-driven self-luminous element.

19. The display device according to claim 1, wherein the display element is an organic EL element or a liquid crystal element.

20. An electronic device comprising:
a display device; and
a video signal generation unit that generates a video signal displayed on the display device,
wherein the display device includes:
a display element connected between a first node and a second node;
a first transistor that performs control to supply a current corresponding to a gradation to the first node; and
a pulse generation unit that supplies a pulse signal to the second node.
